# EUROPÄISCHE PATENTANMELDUNG

(11) **EP 1 148 108 A1**
(43) Veröffentlichungstag der Anmeldung: **24.10.2001**
(21) Anmeldenummer: 01109278.0
(22) Anmeldetag: 17.04.2001
(51) Int. Cl.: C09K 5/14

(54) **Speichermedien für Latentwärmespeicher**

(30) Priorität: 17.04.2000 DE 10018938
(71) Anmelder: MERCK PATENT GmbH, 64293 Darmstadt (DE)
(72) Erfinder: Neuschütz, Mark, Dr., 64285 Darmstadt (DE); Glausch, Ralf, Dr., 64367 Mühltal (DE); Lotz, Natascha, 64390 Erzhausen (DE); Gally, Joachim, 64291 Darmstadt (DE); Heider, Udo, Dr., 64560 Riedstadt (DE)

(57) **Zusammenfassung**

Die vorliegende Erfindung betrifft Mittel zur Speicherung von Wärmeenergie in Form von Phasenumwandlungswärme und deren Verwendung. Die erfindungsgemäßen Mittel zur Speicherung von Wärme, enthalten mindestens ein Wärmespeicherungsmaterial und mindestens ein Hilfsmittel und sind dadurch gekennzeichnet, dass das Mittel mindestens ein Wärmespeicherungsmaterial enthält, das mindestens einen fest-fest-Phasenübergang aufweist und im gesamten Anwendungsbereich fest ist. Bevorzugte Wärmespeicherungsmaterialien sind Verbindungen, die der Summenformel 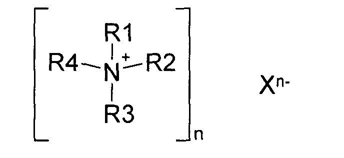 gehorchen, wobei R1, R2, R3 und R4 jeweils unabhängig voneinander ausgewählt sind aus der Gruppe, die die Reste H, C₁-C₃₀-Alkyl oder C₁-C₃₀-Hydroxyalkyl enthält, und Xⁿ⁻ ausgewählt ist aus der Gruppe der monoatoomaren und komplexen anorganischen Anionen, vorzugsweise aus der Gruppe, die Fluorid, Chlorid, Bromid, lodid, Nitrat, Chlorat, Perchlorat, (Hydrogen-)Sulfat, ((Di-)Hydrogen-)Phosphat, Tetrachlorchromat, Tetrachlormanganat, Tetrachlorcadmat, Tetrachlorpalladat, Tetrachlorferrat enthält, oder aus der Gruppe der organischen Anionen, insbesondere der organischen Säureanionen, wie Formiat, Acetat, Propionat, Butyrat, Caprat, Stearat, Palmitat, Acrylat, Oleat, Oxalat, Malonat, Succinat, Glutarat, Benzoat, 2-Nitrobenzoat, Salicylat und Phenylacetat, wobei n sich aus der lonenladung des Anions ergibt.

## Beschreibung

Die vorliegende Erfindung betrifft Mittel zur Speicherung von Wärmeenergie in Form von Phasenumwandlungswärme und deren Verwendung.

In technischen Prozessen müssen oft Wärmespitzen oder -defizite vermieden werden, d.h. es muss thermostatisiert werden. Üblicherweise werden dazu Wärmeaustauscher verwendet. Sie enthalten Wärmeübertragungsmittel die Wärme von einem Ort oder Medium zu einem anderen transportieren. Um Wärmespitzen abzuführen wird z.B. die Abgabe der Wärme über einen Wärmetauscher an die Luft genutzt. Diese Wärme steht dann allerdings nicht mehr zum Ausgleich von Wärmedefiziten zur Verfügung. Dieses Problem löst der Einsatz von Wärmespeichern.

Als Speichermedien bekannt sind z.B. Wasser oder Steine/Beton um fühlbare ("sensible") Wärme zu speichern oder Phasenwechselmaterialien (Phase Change Materials, PCM) wie Salze, Salzhydrate oder deren Gemische um Wärme in Form von Schmelzwärme ("latenter" Wärme) zu speichern.

Es ist bekannt, dass beim Schmelzen einer Substanz, d.h. beim Übergang von der festen in die flüssige Phase, Wärme verbraucht, d.h. aufgenommen wird, die, solange der flüssige Zustand bestehen bleibt, latent gespeichert wird, und dass diese latente Wärme beim Erstarren, d.h. beim Übergang von der flüssigen in die feste Phase, wieder frei wird.

Grundsätzlich ist für das Laden eines Wärmespeichers eine höhere Temperatur erforderlich als beim Entladen erhalten werden kann, da für den Transport/Fluss von Wärme eine Temperaturdifferenz erforderlich ist. Die Qualität der Wärme ist dabei von der Temperatur, bei der sie wieder zur Verfügung steht, abhängig: Je höher die Temperatur ist, desto vielseitiger kann die Wärme eingesetzt werden. Aus diesem Grund ist es erstrebenswert, dass das Temperaturniveau bei der Speicherung so wenig wie möglich absinkt.

Bei sensibler Wärmespeicherung (z.B. durch Erhitzen von Wasser) ist mit dem Eintrag von Wärme eine stetige Erhitzung des Speichermaterials verbunden (und umgekehrt beim Entladen), während latente Wärme bei der Schmelztemperatur des PCM gespeichert und entladen wird. Latente Wärmespeicherung hat daher gegenüber sensibler Wärmespeicherung den Vorteil, dass sich der Temperaturverlust auf den Verlust beim Wärmetransport vom und zum Speicher beschränkt.
Bislang werden als Speichermedium in Latentwärmespeichern üblicherweise Substanzen eingesetzt, die im für die Anwendung wesentlichen Temperaturbereich einen fest-flüssig-Phasenübergang aufweisen, d.h. Substanzen, die bei der Anwendung schmelzen.

So ist aus der Literatur die Verwendung von Paraffinen als Speichermedium in Latentwärmespeichern bekannt. In der Internationalen Patentanmeldung WO 93/15625 werden Schuhsohlen beschrieben, in denen PCM-haltige Mikrokapseln enthalten sind. Dabei werden als PCM entweder Paraffine oder kristallines 2,2,-Dimethyl-1,3-propandiol bzw. 2-Hydroxymethyl-2-methyl-1,3-propandiol vorgeschlagen. In der Anmeldung WO 93/24241 sind Gewebe beschrieben, die mit einem Coating, das derartige Mikrokapseln und Bindemittel enthält, beschichtet sind. Vorzugsweise werden hier paraffinische Kohlenwasserstoffe mit 13 bis 28 Kohlenstoffatomen eingesetzt. In dem Europäischen Patent EP-B-306 202 sind Fasern mit Wärmespeichereigenschaften beschrieben, wobei das Speichermedium ein paraffinischer Kohlenwasserstoff oder ein kristalliner Kunststoff ist und das Speichermaterial in Form von Mikrokapseln in das Fasergrundmaterial integriert ist.

In dem US-Patent US 5 728 316 werden Salzgemische auf Basis von Magnesium- und Lithiumnitrat zur Speicherung und Nutzung von Wärmenergie empfohlen. Die Wärmespeicherung erfolgt dabei in der Schmelze oberhalb der Schmelztemperatur von 75,6°C.

Bei den genannten Speichermedium in Latentwärmespeichern erfolgt während der Anwendung ein Übergang in den flüssigen Zustand. Damit sind Probleme beim technischen Einsatz der Speichermedien in Latentwärmespeichern verbunden, da grundsätzlich eine Versiegelung oder Verkapselung erfolgen muss, die einen Flüssigkeitsaustritt, der zu Substanzverlust bzw. Verunreinigung der Umgebung führt, verhindert. Dies erfordert gerade beim Einsatz in oder auf flexiblen Gebilden, wie beispielsweise Fasern, Geweben oder Schäumen in der Regel eine Mikroverkapselung der Wärmespeichermaterialien, die oft jedoch nur unvollständig erfolgt bzw. technisch sehr anspruchsvoll und dadurch teuer ist. Beispielsweise ist es, wie in dem Patent EP-B-306 202 beschrieben, bevorzugt, wenn diese Mikrokapseln doppelte Wände aufweisen.

Darüberhinaus steigt der Dampfdruck vieler potentiell geeigneter Verbindungen beim Schmelzen stark an, so dass die Flüchtigkeit der Schmelzen einer Langzeitanwendung der Speichermaterialen oft entgegensteht. Beim technischen Einsatz von schmelzenden PCM entstehen häufig Probleme durch starke Volumenveränderungen beim Aufschmelzen vieler Substanzen.

Daher besteht ein Bedarf nach Speichermedium für Latentwärmespeicher, bei deren Anwendung die genannten Probleme nicht auftreten.

Jetzt wurde überraschend gefunden, dass sich auch bestimmte Substanzen, die im Anwendungsbereich einen fest-fest-Übergang aufweisen, als Wärmespeicherungsmaterialen eignen. Da diese Substanzen während der gesamten Anwendung fest bleiben, entfällt das Erfordernis der Verkapselung. Ein Verlust des Speichermediums oder eine Verunreinigung der Umgebung durch die Schmelze des Speichermediums in Latentwärmespeicherns kann so ausgeschlossen werden.

Ein erster Gegenstand der vorliegenden Erfindung ist dementsprechend ein Mittel zur Speicherung von Wärme, enthaltend mindestens ein Wärmespeicherungsmaterial und mindestens ein Hilfsmittel, dadurch gekennzeichnet, dass das Mittel mindestens ein Wärmespeicherungsmaterial enthält, das mindestens einen fest-fest-Phasenübergang aufweist und im gesamten Anwendungsbereich fest ist.

Ein zweiter Erfindungsgegenstand ist die Verwendung von Verbindungen, die mindestens einen fest-fest-Phasenübergang aufweisen als Speichermedium in Latentwärmespeichern.

Als Vorteile dieser Wärmespeichermaterialien sind in erster Linie:
- der feste Zustand des Speichermediums mit seiner im Vergleich zu Flüssigkeiten erleichterten Handhabung,
- die geringe Volumenänderung beim Phasenübergang, die eine Einpassung in komplexe Bauteile erlaubt,
- und der geringe Dampfdruck der wärmespeichernden Hochtemperaturphase zu nennen.

Bei dem Wärmespeicherungsmaterial handelt es sich dabei vorzugsweise um eine Verbindung, die der Summenformel 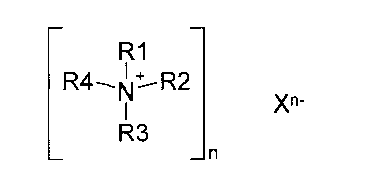 gehorcht, wobei R1, R2, R3 und R4 jeweils unabhängig voneinander ausgewählt sind aus der Gruppe, die die Reste H, C₁-C₃₀-Alkyl oder C₁-C₃₀-Hydroxyalkyl enthält, und Xⁿ⁻ ausgewählt ist aus der Gruppe der monoatomaren und komplexen anorganischen Anionen oder aus der Gruppe der organischen Anionen, wobei n sich aus der lonenladung des Anions ergibt. Als monoatomare anorganische Anionen werden dabei vorzugsweise Anionen aus der Gruppe, die Fluorid, Chlorid, Bromid und lodid enthält, eingesetzt. Komplexe anorganische Anionen im Sinne der vorliegenden Erfindung sind alle Anionen, die aus mindestens 2 verschiedenen Elementen aufgebaut sind, vorzugsweise sind es solche Anionen, die ein Zentralatom und Liganden aufweisen, insbesondere sind hier Nitrat, Chlorat, Perchlorat, (Hydrogen-)Sulfat, ((Di-)Hydrogen-)Phosphat, Tetrachlorchromat, Tetrachlormanganat, Tetrachlorcadmat, Tetrachlorpalladat und Tetrachlorferrat zu nennen. Unter den organischen Anionen werden insbesondere Anionen der organischen Säuren, wie Formiat, Acetat, Propionat, Butyrat, Caprat, Stearat, Palmitat, Acrylat, Oleat, Oxalat, Malonat, Succinat, Glutarat, Benzoat, 2-Nitrobenzoat, Salicylat und Phenylacetat, eingesetzt.

Einsatzgebiete dieser Verbindungen finden sich aufgrund ihrer günstigen Übergangstemperaturen und hohen Übergangsenthalpien im Bereich der Thermostatierung, so dass ein weiterer Gegenstand der vorliegenden Erfindung die Verwendung der o.g. Verbindungen zur Thermostatisierung ist. Thermostatisierung im Sinne der vorliegenden Erfindung meint dabei sowohl die thermische Isolation und damit das konstant Halten einer Temperatur, wie auch das Abfangen kurzzeitiger Temperaturschwankungen oder -spitzen. Anwendungen können dabei sowohl in einer Wärmespeicherung und gezielten Abgabe, als auch in einer Aufnahme von Wärme und damit verbunden einer Kühlung bestehen.

Dabei sind bevorzugte Wärmespeicherungsmaterialien solche, bei denen es sich um eine Verbindung handelt, die in ihrer Tieftemperaturform in einem schichtförmigen Perowskit-Typ kristallisiert. Erfindungsgemäß bevorzugt sind unter diesen Verbindungen wiederum die Monoalkylammoniumtetrachlorchromate, Monoalkylammonium-tetrachlormanganate, Monoalkylammonium-tetrachlorcadmate, Monoalkylammonium-tetrachlorpalladate und Monoalkylammonium-tetrachlorferrate mit Alkylkettenlängen aus dem Bereich von C₁-C₃₀. Insbesondere bevorzugt sind die oben genannten Monoalkylammonium-tetrachlormetallate mit C₁-, C₂-, C₄-, C₆-, C₈-, C₁₀-, C₁₂-, C₁₄-, C₁₆- oder C₁₈-Alkylketten. Physikalische Eigenschaften dieser Verbindungen sind beispielsweise in den Publikationen G. F. Needham, R. D. Willett, H. F. Franzen, J. Phys. Chem. 88 (1984) 674 und W. Depmeier, Ferroelectrics 24 (1981) 81 beschrieben.

Bei einer anderen erfindungsgemäß besonders bevorzugten Substanzklasse von Wärmespeicherungsmaterialen handelt es sich um Dialkylammoniumsalze. Vorzugsweise werden solche Dialkylammoniumsalze eingesetzt, deren Reste R1 und R2 gleiche C-Kettenlängen aufweisen und bei denen die Reste R3 und R4 H sind. Dabei können diese Dialkylammoniumsalze in reiner, kristallliner Form eingesetzt werden. Es kann jedoch, insbesondere um gezielt Übergangstemperaturen einzustellen, auch erwünscht sein, dass Mischkristalle verschiedener Dialkylammoniumsalze eingesetzt werden.

Zu den erfindungsgemäß besonders bevorzugten Wärmespeicherungsmaterialien gehören die symmetrischen Dialkylammoniumsalze z.B.: Diethylammoniumchlorid, Dipropylammoniumchlorid, Dibutylammoniumchlorid, Dipentylammoniumchlorid, Dihexylammoniumchlorid, Dioctylammoniumchlorid, Didecylammoniumchlorid, Didodecylammoniumchlorid, Dioctadecylammoniumchlorid, Diethylammoniumbromid, Dipropylammoniumbromid, Dibutylammoniumbromid, Dipentylammoniumbromid, Dihexylammoniumbromid, Dioctylammoniumbromid, Didecylammoniumbromid, Didodecylammoniumbromid, Dioctadecylammoniumbromid, Diethylammoniumnitrat, Dipropylammoniumnitrat, Dibutylammoniumnitrat, Dipentylammoniumnitrat, Dihexylammoniumnitrat, Dioctylammoniumnitrat, Didecylammoniumnitrat, Dioctylammoniumchlorat, Dioctylammoniumacetat, Dioctylammoniumformiat, Didecylammoniumchlorat, Didecylammoniumacetat, Didecylammonium-formiat, Didodecylammoniumchlorat, Didodecylammoniumformiat, Didodecylammoniumhydrogensulfat, Didodecylammoniumpropionat, Dibutylammonium-2-nitrobenzoat, Diundecylammoniumnitrat und Didodecylammoniumnitrat. Die physikalisch-thermische Chrakterisierung der Dialkylammoniumchloride ist in der Publikation M. J. M. van Oort, M. A. White, Ber. Bunsenges. Phys. Chem. 92 (1988) 168 zu finden. Welche Verbindung im Einzelfall am besten geeignet ist, hängt vorwiegend vom Einsatzbereich der Latentwärmespeicher ab. Im allgemeinen sind jedoch die Dialkylammoniumsalze mit hohen Übergangsenthalpien besonders bevorzugt. Hier sind insbesondere Dioctylammoniumchlorid, Didecylammoniumchlorid, Didodecylammoniumchlorid, Dioctadecylammoniumchlorid, Dihexylammoniumbromid, Didecylammoniumbromid, Didodecylammoniumbromid, Dioctadecylammoniumbromid, Dihexylammoniumnitrat, Dioctylammoniumnitrat, Didecylammoniumnitrat, Dioctylammoniumchlorat, Dioctylammoniumacetat, Dioctylammoniumformiat, Didecylammoniumchlorat, Didecylammoniumacetat, Didecylammonium-formiat, Didodecylammoniumchlorat, Didodecylammoniumformiat, Didodecylammoniumhydrogensulfat, Didodecylammoniumpropionat, Dibutylammonium-2-nitrobenzoat und Didodecylammoniumnitrat zu nennen.

Beispielsweise ist es für Anwendungen im Bereich von thermostatierender Kleidung, wie z.B. Wintermäntel oder Skijacken oder Schuhen vorteilhaft, dass die Übergangstemperaturen unterhalb der Körpertemperatur und deutlich oberhalb der Frostgrenze liegen. Die gleichen Anforderungen müssen Verbindungen erfüllen, die sich zur Temperierung von Gebäuden eignen. Für derartige Anwendungen besonders bevorzugte Dialkylammoniumsalze sind Dioctylammoniumchlorid, Dihexylammoniumbromid, Dioctylammoniumbromid und Dihexylammoniumnitrat.

Dihexylammoniumnitrat eignet sich darüber hinaus aufgrund seiner Übergangstemperatur von 11°C hervorragend für Anwendungen, bei denen eine leichte Kühlung erforderlich ist, während sich die Verbindungen mit Übergangstemperaturen unter 0°C für Kühlmedien eignen, die Temperaturen unterhalb des Gefrierpunktes von Wasser aufrechterhalten sollen. Zur technischen Wärmespeicherung bzw. dem Warmhalten von Speisen bieten sich wiederum Verbindungen an, die eine Übergangstemperatur im Bereich von 50°C bis unter 100°C aufweisen. Hier sind insbesondere die Dialkylammoniumchloride, -bromide und -nitrate mit Alkylketten von mindestens 10 C-Atomen Länge von Vorteil.

Wesentlich für die Anwendung der Speichermedien in Latentwärmespeichern ist weiterhin, dass die Übergangsenthalpie ein gewisses Energieminimum nicht unterschreitet, da sonst zur Speicherung der Energie zu große Substanzmengen benötigt werden. Erfindungsgemäß bevorzugt ist es daher, wenn das Wärmespeicherungsmaterial im Anwendungsbereich einen fest-fest-Phasenübergang aufweist, der eine Enthalpie von mindestens 50 J/g, vorzugsweise von mindestens 80 J/g und insbesondere bevorzugt von mindestens 150 J/g aufweist. Dabei erscheinen die im Vergleich zu üblichen Schmelzwärmen oft niedrigeren Enthalpien der fest-fest-Phasenübergänge auf den ersten Blick als ein Nachteil dieser Substanzen im Vergleich zu den schmelzenden PCM. Da solche schmelzenden PCM jedoch verkapselt, insbesondere mikroverkapselt eingesetzt werden, muss bei der Enthalpie pro Gramm eingesetzter Substanz auch das Verkapselungsmaterial berücksichtigt werden.

Da es für die Energieausbeute und schnelle Aufnahme und Abgabe von Energie wichtig ist, dass das Wärmespeicherungsmaterial eine große Oberfläche aufweist bzw. fein in einem Medium / Hilfsmittel verteilt ist, ist es erfindungsgemäß von Vorteil, wenn das Wärmespeicherungsmaterial eine durchschnittliche Kristallitgröße im Bereich von 0,1 bis 1000 µm, vorzugsweise im Bereich von 1 bis 100 µm aufweist.

Für die meisten Verwendungszwecke von Latentwärmespeichern ist es weiter von Vorteil, wenn das Speichermaterial wasserunlöslich ist, da dann Feuchtigkeitseinwirkung, beispielsweise beim Waschen oder durch Regen nicht zu Substanzverlusten führt.

Wie bereits weiter oben erwähnt ist es je nach Anwendungszweck erforderlich, dass das Mittel zur Speicherung von Wärme bestimmte Übergangstemperaturen aufweist. Üblicherweise liegt der Anwendungsbereich der erfindungsgemäßen Speichermedium in Latentwärmespeichern im Temperaturbereich zwischen -100°C und 150°C, in der Regel im Temperaturbereich von -50°C bis 100°C und meistens sogar im Temperaturbereich von 0°C bis 90°C. Dementsprechend ist es für die erfindungsgemäßen Mittel bevorzugt, wenn Wärmespeicherungsmaterialien in ihnen enthalten sind, die in diesen Temperaturbereichen einen fest-fest-Phasenübergang aufweisen.

Die erfindungsgemäßen Mittel zur Speicherung von Wärme enthalten neben dem eigentlichen Wärmespeicherungsmaterial mindestens ein Hilfsmittel. In einer bevorzugten Ausführungsform der Erfindung handelt es sich bei mindestens einem Hilfsmittel um eine Substanz oder Zubereitung mit guter thermischer Leitfähigkeit, insbesondere um ein Metallpulver, -granulat oder Graphit. Dabei liegt das Wärmespeicherungsmaterial vorzugsweise in inniger Mischung mit dem Hilfsmittel vor, wobei das gesamte Mittel vorzugsweise entweder als lose Schüttung oder als Formkörper vorliegt. Unter Formkörpern werden dabei insbesondere alle Gebilde verstanden, die sich durch Kompaktierungsmethoden, wie Pelletierung, Tablettierung, Walzenkompaktierung oder Extrusion, herstellen lassen. Dabei können die Formkörper die verschiedensten Raumformen, wie beispielsweise Kugel-, Würfel- oder Quaderform, annehmen. In einer weiteren besonders bevorzugten Ausführungsform enthalten die hier beschriebenen Mischungen oder Formkörper als zusätzliches Hilfsmittel Paraffin. Paraffin wird insbesondere dann eingesetzt, wenn bei der Anwendung ein inniger Kontakt zwischen dem Mittel zur Speicherung von Wärme und einem Bauteil hergestellt werden soll. Beispielsweise kann so der passgenaue Einbau von Latentwärmespeichern zur Kühlung elektronischer Bauteile erfolgen. Bei der Montage der Wärmespeicher ist die Handhabung insbesondere eines oben beschriebenen Formkörpers einfach, bei der Anwendung schmilzt das Paraffin, verdrängt Luft an den Kontaktflächen und sorgt so für einen engen Kontakt zwischen Wärmespeichermaterial und Bauteil. Vorzugsweise finden derartige Mittel daher Verwendung in Vorrichtungen zur Kühlung von Elektronikbauteilen.

In einer ebenfalls bevorzugten Ausführungsform der Erfindung handelt es sich bei mindestens einem Hilfsmittel um ein Bindemittel, vorzugsweise um ein polymeres Bindemittel. Dabei liegen die Kristallite des Wärmespeicherungsmaterials vorzugsweise in feiner Verteilung in dem Bindemittel vor. Die Wärmespeicherungsmittel können dann in Form von Fasern vorliegen, wobei das Bindemittel gleichzeitig als Fasergrundmaterial dient und vorzugsweise ein synthetisches Polymer ist. Erfindungsgemäß können Fasern, die das Wärmespeicherungsmaterial enthalten auch so aufgebaut sein, dass eine natürliche oder künstliche Faser das Grundgerüst der Faser bildet und das oder die Bindemittel zusammen mit dem Wärmespeicherungsmaterial eine Beschichtung um diese Faser bildet. Aus diesen Fasern können dann Gewebe mit thermostatisierenden Eigenschaften erhalten werden. Ein anderer Weg solche wärmespeichernden Gewebe zu erhalten, führt über die Beschichtung eines fertigen Gewebes mit dem Mittel, das Wärmespeichermedium und Bindemittel enthält. Eine derartige Beschichtung kann erfindungsgemäß auch auf einer anderen Oberfläche vorliegen.

Bei den vorzugsweise polymeren Bindemitteln, die enthalten sein können, kann es sich um jegliche Polymere handeln, die sich dem Anwendungszweck entsprechend als Bindemittel eignen. Vorzugsweise ist das polymere Bindemittel dabei ausgewählt aus härtbaren Polymeren oder Polymervorstufen, die wiederum vorzugsweise ausgewählt sind aus der Gruppe, die aus Polyurethanen, Nitrilkautschuk, Chloropren, Polyvinylchlorid, Siliconen, Ethylen-Vinylacetat-Copolymeren und Polyacrylaten besteht. Wie die geeignete Einarbeitung der Wärmespeichrungsmaterialen in diese polymeren Bindemittel erfolgt, ist dem Fachmann auf diesem Gebiet wohl bekannt. Es bereitet ihm keine Schwierigkeiten gegebenenfalls die nötigen Zusatzstoffe, wie beispielsweise Emulgatoren zu finden, die eine solche Mischung stabilisieren.

Die Mittel zur Speicherung von Wärme liegen in einer weiteren Variante der Erfindung in Form eines offen-zelligen oder geschlossen-zelligen Schaumes vor, wobei das Hilfsmittel, bei dem es sich vorzugsweise um ein Polymeres handelt, die Matrix des Schaumes bildet, in der die Kristallite des Wärmespeicherungsmaterials in feiner Verteilung vorliegen. Derartige Schäume können zur thermischen Isolation und vorzugsweise zur thermostatierenden Ausrüstung von Kleidung verwendet werden. Dabei können die Schäume entweder auf Gewebeschichten aufgebracht oder zwischen Gewebeschichten eingelagert sein. Denkbar ist auch der unmittelbare Einsatz der Schäume beispielsweise als Schuhsohlen. solche thermostatierende Kleidung kann den verschiedensten Einsatzzwecken dienen. Ein verbesserte Wärmeregulierung im Vergleich zu herkömmlicher Winterkleidung ist nur ein vorteilhaftes Anwendungsgebiet. Vielversprechend ist auch Schutzkleidung beispielsweise für Feuerwehrleute, die Hitzespitzen aufnimmt und so vor Verbrennungen schützt.

In einer ebenfalls bevorzugten Variante der Erfindung handelt es sich bei dem Bindemittel um ein anorganisches Bindemittel auf Basis von wasserunlöslichen Silicaten, Phosphaten, Sulfaten oder Metalloxiden, vorzugsweise um Zement oder Gips. Eine erfindungsgemäß bevorzugte Verwendung solcher Mittel besteht in der Thermostatierung von Gebäuden. Dabei kann entweder das Baumaterial direkt von dem erfindungsgemäßen Mittel zur Wärmespeicherung gebildet werden oder es können Einlagerungen in die Bausubstanz oder Beschichtungen der Bausubstanz mit dem Wärmespeicherungsmittel erfolgen.

Die nachfolgenden Beispiele sollen die Erfindung näher erläutern, ohne sie jedoch zu beschränken.

### Beispiele

### Beispiel 1:

Es wurden für verschiedene fest-fest Phasenwechselmaterialien fest-fest Phasenübergangsmessungen durchgeführt. Außerdem wurden die fest-flüssig Phasenübergänge (Schmelzpunkt) gemessen. Die Ergebnisse sind in der folgenden Tabelle zusammengestellt

**Tabelle 2:**

| Beispiele für fest-fest und fest-flüssig Phasenübergänge | | | | | | | |
|---|---|---|---|---|---|---|---|
| Amine | Acid | Heating onset | Heating enthalpy | Cooling onset | Cooling enthalpy | Subcooling | Meltingpoint |
| Dihexylamine | Hydrogen chloride | 6°C | 51 J/g | 3°C | 51 J/g | 3°C | >100°C |
| Dihexylamine | Nitric acid | 10°C | 110 J/g | -8°C | 99 J/g | 18°C | >100°C |
| Dioctylamine | Chloric acid | 14°C | 112 J/g | 14°C | 122 J/g | 0°C | 37°C |
| Dihexylamine | Hydrogen bromide | 19°C | 72 J/g | 14°C | 71 J/g | 5°C | >100°C |
| Dioctylamine | Hydrogen chloride | 21°C | 87 J/g | 19°C | 74 J/g | 2°C | >100°C |
| Dioctylamine | Hydrogen bromide | 29°C | 79 J/g | 27°C | 79 J/g | 2°C | >100°C |
| Dioctylamine | Acetic acid | 36°C | 177 J/g | 20°C | 163 J/g | 16°C | 40°C |
| Dioctylamine | Nitric acid | 44°C | 154 J/g | 26°C | 144 J/g | 18°C | >100°C |
| Dioctylamine | Formic acid | 45°C | 145 J/g | 17°C | 127 J/g | 28°C | >100°C |
| Didecylamine | Hydrogen chloride | 49°C | 117 J/g | 43°C | 113 J/g | 5°C | >100°C |
| Didecylamine | Chloric acid | 54°C | 140 J/g | 41°C | 131 J/g | 13°C | >100°C |
| Didodecylamine | Chloric acid | 54°C | 168 J/g | 47°C | 155 J/g | 6°C | >100°C |
| Didodecylamine | Formic acid | 56°C | 156 J/g | 45°C | 145 J/g | 11°C | 87°C |
| Didecylamine | Hydrogen bromide | 56°C | 102 J/g | 50°C | 100 J/g | 6°C | >100°C |
| Didecylamine | Nitric acid | 57°C | 153 J/g | 44°C | 149 J/g | 13°C | >100°C |
| Didecylamine | Acetic acid | 58°C | 151 J/g | 53°C | 140 J/g | 5°C | 68°C |
| Didodecylamine | Acetic acid | 64°C | 178 J/g | 63°C | 163 J/g | 1°C | 76°C |
| Didodecylamine | Sulfuric acid | 64°C | 50 J/g | 61°C | 49 J/g | 3°C | 97°C |
| Didodecylamine | Hydrogen chloride | 65°C | 132 J/g | 60°C | 127 J/g | 5°C | >100°C |
| Dibutylamine | 2-Nitrobenzoic acid | 66°C | 45 J/g | 41°C | 40 J/g | 25°C | 118°C |
| Didodecylamine | Propionic acid | 66°C | 169 J/g | 66°C | 164 J/g | 1°C | 73°C |
| Didecylamine | Formic acid | 67°C | 161 J/g | 46°C | 148 J/g | 21°C | 79°C |
| Didodecylamine | Nitric acid | 69°C | 160 J/g | 62°C | 161 J/g | 7°C | >100°C |
| Didodecylamine | Hydrogen bromide | 78°C | 124 J/g | 65°C | 119 J/g | 6°C | >100°C |

### Meßbedingungen:

a) DSC: Mettler Toledo, 2-10 mg Probe im hermetisch verschlossenen Aluminium-Tiegel, Meßzyklus Raumtemperatur/120°C/-50°C/RT, 5 Zyklen (4. und 5. Zyklus ausgewertet), Heiz- und Kühlrate 5K/min
b) Schmelzpunkt: Büchi Melting-Point Apparatur, Temperaturintervall 30 bis 100°C, Heizrate 10K/min

### Beispiel 2

### Herstellung von Preßlingen

Das Aktivmaterial Didodecylammoniumchlorid (01/EX16) wurde pur oder gemeinsam mit dem entsprechenden Anteil Graphit KS6 in der Labormühle von Ika vermahlen. Die Mahldauer betrug 2x 30 Sekunden.

**Tabelle 3:**

| Probenvorbereitung und -bezeichnung | | | |
|---|---|---|---|
| **Ausgangssubstanz** | **Menge** | **Bemerkung** | **Neue Bezeichnung** |
| 01/EX16 pur | 1 g | ohne Vermahlung | 01/EX/16 |
| 01/EX/16+ 10% Graphit | 4g | je 2g wurden gleichzeitig vermahlen | 01/NP/2.1 |
| 01/EX/16 pur | 2g | vermahlen | 01/NP/2.2 |

Es wurden je 0,5 g eingewogen und in die Einfüllöffnung der Preßlingsform gegeben. Mit dem Handhebel wurde ein Anpreßdruck von 5t eingestellt. Dieser wurde 1 min beibehalten und gegebenenfalls nachgesteuert.

Es wurden auch Versuche mit höherem Anpreßdruck durchgeführt. 2,5g Material (01/NP/2.1) wurden 1min bei einem Anpreßdruck von 20 t gepreßt.

**Tabelle 4:**

| Preßlinge | | | | |
|---|---|---|---|---|
| Proben Nr. | Einwaage | Höhe | Durchmesser | Bemerkungen |
| 01/EX/16 | 1,005 g | 0,5 cm | 1,6 cm | Partikel sind sichtbar, kein gleichmäßiger Preßling, stabil |
| 01/NP/2.1 | 0,5036 g | 0,2 cm | 1,6 cm | sehr stabiler Preßling, glatte Oberfläche |
| 01/NP/2.1 | 0,4993 g | 0,2 cm | 1,6 cm | sehr stabiler Preßling, glatte Oberfläche |
| 01/NP/2.2 | 0,5002 g | 0,2 cm | 1,6 cm | sehr stabiler Preßling, glatte Oberfläche |
| 01/NP/2.1 | 2,4200 g | 0,2 cm | 4,0 cm | sehr stabiler Preßling, glatte Oberfläche |

## Patentansprüche

1. Mittel zur Speicherung von Wärme, enthaltend mindestens ein Wärmespeicherungsmaterial und mindestens ein Hilfsmittel, **dadurch gekennzeichnet, dass** das Mittel mindestens ein Wärmespeicherungsmaterial enthält, das mindestens einen fest-fest-Phasenübergang aufweist und im gesamten Anwendungsbereich fest ist.

2. Mittel zur Speicherung von Wärme nach Anspruch 1, **dadurch gekennzeichnet, dass** es sich bei einem Wärmespeicherungsmaterial um eine Verbindung handelt, die der Summenformel 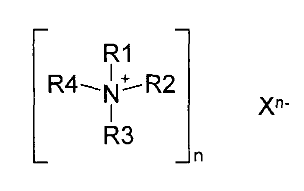 gehorcht, wobei R1, R2, R3 und R4 jeweils unabhängig voneinander ausgewählt sind aus der Gruppe, die die Reste H, C₁-C₃₀-Alkyl oder C₁-C₃₀-Hydroxyalkyl enthält, und Xⁿ⁻ ausgewählt ist aus der Gruppe der monoatoomaren und komplexen anorganischen Anionen, vorzugsweise aus der Gruppe, die Fluorid, Chlorid, Bromid, lodid, Nitrat, Chlorat, Perchlorat, (Hydrogen-)Sulfat, ((Di-)Hydrogen-)Phosphat, Tetrachlorchromat, Tetrachlormanganat, Tetrachlorcadmat, Tetrachlorpalladat, Tetrachlorferrat enthält, oder aus der Gruppe der organischen Anionen, insbesondere der organischen Säureanionen, wie Formiat, Acetat, Propionat, Butyrat, Caprat, Stearat, Palmitat, Acrylat, Oleat, Oxalat, Malonat, Succinat, Glutarat, Benzoat, 2-Nitrobenzoat, Salicylat und Phenylacetat, wobei n sich aus der lonenladung des Anions ergibt.

3. Mittel zur Speicherung von Wärme nach einem der Ansprüche 1 oder 2, **dadurch gekennzeichnet, dass** es sich bei einem Wärmespeicherungsmaterial um eine Verbindung handelt, die in ihrer Tieftemperaturform in einem schichtförmigen Perowskit-Typ kristallisiert und vorzugsweise ausgewählt ist aus den Monoalkylammonium-tetrachlorchromaten, Monoalkylammoniumtetrachlormanganaten, Monoalkylammonium-tetrachlorcadmaten, Monoalkylammonium-tetrachlorpalladaten, Monoalkylammonium-tetrachlorferraten mit Alkylkettenlängen aus dem Bereich von C₁-C₃₀, insbesondere von C₁-, C₂-, C₄-, C₆-, C₈-, C₁₀-, C₁₂-, C₁₄-, C₁₆- oder C₁₈-Alkyl.

4. Mittel zur Speicherung von Wärme nach Anspruch 2, **dadurch gekennzeichnet, dass** es sich bei einem Wärmespeicherungsmaterial um ein Dialkylammoniumsalz handelt, bei dem vorzugsweise R1 und R2 gleiche C-Kettenlängen aufweisen und R3 und R4 H sind.

5. Mittel zur Speicherung von Wärme nach einem der Ansprüche 2 oder 4, **dadurch gekennzeichnet, dass** es sich bei einem Wärmespeicherungsmaterial um Mischkristalle verschiedener Dialkylammoniumsalze handelt.

6. Mittel zur Speicherung von Wärme nach einem der Ansprüche 2 bzw. 4 oder 5, **dadurch gekennzeichnet, dass** es sich bei einem Wärmespeicherungsmaterial um eine Verbindung aus der Gruppe handelt, die die Elemente Diethylammoniumchlorid, Dipropylammoniumchlorid, Dibutylammoniumchlorid, Dipentylammoniumchlorid, Dihexylammoniumchlorid, Dioctylammoniumchlorid, Didecylammoniumchlorid, Didodecylammoniumchlorid, Dioctadecylammoniumchlorid, Diethylammoniumbromid, Dipropylammoniumbromid, Dibutylammoniumbromid, Dipentylammoniumbromid, Dihexylammoniumbromid, Dioctylammoniumbromid, Didecylammoniumbromid, Didodecylammoniumbromid, Dioctadecylammoniumbromid, Diethylammoniumnitrat, Dipropylammoniumnitrat, Dibutylammoniumnitrat, Dipentylammoniumnitrat, Dihexylammoniumnitrat, Dioctylammoniumnitrat, Didecylammoniumnitrat und Didodecylammoniumnitrat enthält, wobei es sich insbesondere bevorzugt um eine Verbindung aus der Gruppe Dioctylammoniumchlorid, Didecylammoniumchlorid, Didodecylammoniumchlorid, Dioctadecylammoniumchlorid, Dihexylammoniumbromid, Didecylammoniumbromid, Didodecylammoniumbromid, Dioctadecylammoniumbromid, Dihexylammoniumnitrat, Dioctylammoniumnitrat, Didecylammoniumnitrat, Dioctylammoniumchlorat, Dioctylammoniumacetat, Dioctylammoniumformiat, Didecylammoniumchlorat, Didecylammoniumacetat, Didecylammoniumformiat, Didodecylammoniumchlorat, Didodecylammoniumformiat, Didodecylammoniumhydrogensulfat, Didodecylammoniumpropionat, Dibutylammonium-2-nitrobenzoat und Didodecylammoniumnitrat handelt.

7. Mittel zur Speicherung von Wärme nach einem der Ansprüche 1 bis 6, **dadurch gekennzeichnet, dass** das Wärmespeicherungsmaterial eine durchschnittliche Kristallitgröße im Bereich von 0,1 bis 1000 µm, vorzugsweise im Bereich von 1 bis 100 µm aufweist und das Material wasserunlöslich ist.

8. Mittel zur Speicherung von Wärme nach einem der Ansprüche 1 bis 7, **dadurch gekennzeichnet, dass** das Wärmespeicherungsmaterial im Anwendungsbereich einen fest-fest-Phasenübergang aufweist, der eine Enthalpie von mindestens 50 J/g, vorzugsweise von mindestens 80 J/g und insbesondere bevorzugt von mindestens 150 J/g aufweist.

9. Mittel zur Speicherung von Wärme nach einem der Ansprüche 1 bis 8, **dadurch gekennzeichnet, dass** das Wärmespeicherungsmaterial im Anwendungsbereich einen fest-fest-Phasenübergang aufweist, der im Temperaturbereich zwischen -100°C und 150°C, vorzugsweise im Temperaturbereich von -50°C bis 100°C und insbesondere bevorzugt im Temperaturbereich von 0°C bis 90°C liegt.

10. Mittel zur Speicherung von Wärme nach einem der Ansprüche 1 bis 9, **dadurch gekennzeichnet, dass** es sich bei mindestens einem Hilfsmittel um eine Substanz oder Zubereitung mit guter thermischer Leitfähigkeit, insbesondere um ein Metallpulver oder -granulat oder Graphit handelt, wobei das Wärmespeicherungsmaterial vorzugsweise in inniger Mischung mit dem Hilfsmittel als lose Schüttung oder als Formkörper vorliegt.

11. Mittel zur Speicherung von Wärme nach Anspruch 10, **dadurch gekennzeichnet, dass** es sich bei einem weiteren Hilfsmittel um Paraffin handelt.

12. Mittel zur Speicherung von Wärme nach einem der Ansprüche 1 bis 11, **dadurch gekennzeichnet, dass** es sich bei mindestens einem Hilfsmittel um ein Bindemittel, vorzugsweise um ein polymeres Bindemittel handelt, wobei die Kristallite des Wärmespeicherungsmaterials vorzugsweise in feiner Verteilung in dem Bindemittel vorliegen.

13. Mittel zur Speicherung von Wärme nach Anspruch 12, **dadurch gekennzeichnet, dass** das Mittel in Form von Fasern vorliegt, wobei das Bindemittel gleichzeitig als Fasergrundmaterial dient und vorzugsweise ein synthetisches Polymer ist.

14. Mittel zur Speicherung von Wärme nach Anspruch 12, **dadurch gekennzeichnet, dass** das Mittel in Form von Fasern vorliegt, wobei eine natürliche oder künstliche Faser das Grundgerüst der Faser bildet und das oder die Bindemittel zusammen mit dem Wärmespeicherungsmaterial eine Beschichtung um diese Faser bildet.

15. Mittel zur Speicherung von Wärme nach Anspruch 12, **dadurch gekennzeichnet, dass** das Mittel in Form einer Beschichtung auf einer Oberfläche oder um ein Textilgewebe vorliegt.

16. Mittel zur Speicherung von Wärme nach einem der Ansprüche 12 bis 15,
**dadurch gekennzeichnet, dass** das polymere Bindemittel ausgewählt ist aus härtbaren Polymeren oder Polymervorstufen, die vorzugsweise ausgewählt sind aus der Gruppe, die aus Polyurethanen, Nitrilkautschuk, Chloropren, Polyvinylchlorid, Siliconen, Ethylen-Vinylacetat-Copolymeren und Polyacrylaten besteht.

17. Mittel zur Speicherung von Wärme nach einem der Ansprüche 1 bis 16,
**dadurch gekennzeichnet, dass** das Mittel in Form eines offen-zelligen oder geschlossen-zelligen Schaumes vorliegt, wobei das Hilfsmittel, bei dem es sich vorzugsweise um ein Polymeres handelt, die Matrix des Schaumes bildet, in der die Kristallite des Wärmespeicherungsmaterials in feiner Verteilung vorliegen.

18. Mittel zur Speicherung von Wärme nach Anspruch 12, **dadurch gekennzeichnet, dass** es sich bei dem Bindemittel um ein anorganisches Bindemittel auf Basis von wasserunlöslichen Silicaten, Phosphaten, Sulfaten oder Metalloxiden, vorzugsweise um Zement oder Gips handelt.

19. Verwendung von Verbindungen, die mindestens einen fest-fest-Phasenübergang aufweisen als Speichermedium in Latentwärmespeichern.

20. Verwendung nach Anspruch 19 von Verbindungen, die der Summenformel 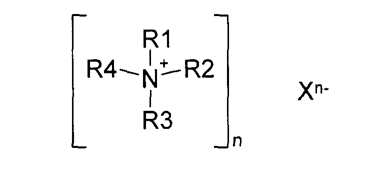 gehorchen, wobei R1, R2, R3 und R4 jeweils unabhängig voneinander ausgewählt sind aus der Gruppe, die die Reste H, C₁-C₃₀-Alkyl oder C₁-C₃₀Hydroxyalkyl enthält, und Xⁿ⁻ ausgewählt ist aus der Gruppe der monoatoomaren und komplexen anorganischen Anionen, vorzugsweise aus der der Gruppe, die Fluorid, Chlorid, Bromid, lodid, Nitrat, Chlorat, Perchlorat, (Hydrogen-)Sulfat, ((Di-)Hydrogen-)Phosphat, Tetrachlorchromat, Tetrachlormanganat, Tetrachlorcadmat, Tetrachlorpalladat, Tetrachlorferrat enthält, oder aus der Gruppe der organischen Anionen, insbesondere der organischen Säureanionen, wie Formiat, Acetat, Propionat, Butyrat, Caprat, Stearat, Palmitat, Acrylat, Oleat, Oxalat, Malonat, Succinat, Glutarat, Benzoat, 2-Nitrobenzoat, Salicylat und Phenylacetat, wobei n sich aus der lonenladung des Anions ergibt.

21. Verwendung von Verbindungen, die der Summenformel 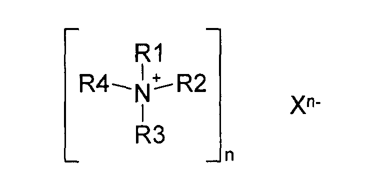 gehorchen, wobei R1, R2, R3 und R4 jeweils unabhängig voneinander ausgewählt sind aus der Gruppe, die die Reste H, C₁-C₃₀-Alkyl oder C₁-C₃₀-Hydroxyalkyl enthält, und Xⁿ⁻ ausgewählt ist aus aus der Gruppe der monoatoomaren und komplexen anorganischen Anionen, vorzugsweise aus der der Gruppe, die Fluorid, Chlorid, Bromid, lodid, Nitrat, Chlorat, Perchlorat, (Hydrogen-)Sulfat, ((Di-)Hydrogen-)Phosphat, Tetrachlorchromat, Tetrachlormanganat, Tetrachlorcadmat, Tetrachlorpalladat, Tetrachlorferrat enthält, oder aus der Gruppe der organischen Anionen, insbesondere der organischen Säureanionen, wie Formiat, Acetat, Propionat, Butyrat, Caprat, Stearat, Palmitat, Acrylat, Oleat, Oxalat, Malonat, Succinat, Glutarat, Benzoat, 2-Nitrobenzoat, Salicylat und Phenylacetat, wobei n sich aus der lonenladung des Anions ergibt, zur Thermostatisierung.

22. Verwendung von Schäumen gemäß Anspruch 17 zur thermostatierenden Ausrüstung von Kleidung.

23. Verwendung von Mitteln gemäß Anspruch 10 oder 11 in Vorrichtungen zur Kühlung von Elektronikbauteilen.

24. Verwendung von Mitteln gemäß Anspruch 18 zur Thermostatierung von Gebäuden.
